# EUROPÄISCHE PATENTSCHRIFT

(11) **EP 1 454 359 B1**
(45) Veröffentlichungstag und Bekanntmachung des Hinweises auf die Patenterteilung: **23.07.2014**
(21) Anmeldenummer: 02796562.3
(22) Anmeldetag: 02.12.2002
(51) Int. Cl.: H01L 29/732, H01L 29/66, H01L 29/08, H01L 29/10

(54) **BIPOLARE HALBLEITERVORRICHTUNG UND VERFAHREN ZU IHRER HERSTELLUNG**
SEMICONDUCTOR DEVICE AND METHOD FOR PRODUCTION THEREOF
DISPOSITIF A SEMICONDUCTEUR ET PROCEDE DE FABRICATION DUDIT DISPOSITIF

(30) Priorität: 30.11.2001 DE 10160509
(43) Veröffentlichungstag der Anmeldung: 08.09.2004
(60) Teilanmeldung: 10184125.2
(73) Patentinhaber: IHP GmbH-Innovations for High Performance Microelectronics / Leibniz-Institut für innovative Mikroelektronik, 15236 Frankfurt / Oder (DE)
(72) Erfinder: HEINEMANN, Bernd, 15234 Frankfurt/Oder (DE); KNOLL, Dieter, 15230 Frankfurt/Oder (DE); EHWALD, Karl-Ernst, 15234 Frankfurt/Oder (DE); RÜCKER, Holger, 15526 Bad Saarow (DE)
(74) Vertreter: Eisenführ Speiser
(86) Internationale Anmeldenummer: PCT/EP2002/013622
(87) Internationale Veröffentlichungsnummer: WO 2003/046948

(56) Entgegenhaltungen:
- EP-A- 0 350 610
- WO-A-00/14806
- WO-A-98/09335
- WO-A-99/17369
- DE-A- 19 611 692
- DE-A- 19 957 113
- GB-A- 1 127 161
- US-A- 4 381 953
- US-A- 5 374 846
- US-A- 5 571 731
- US-A- 5 950 080
- US-B1- 6 171 894
- US-B1- 6 198 156

## Beschreibung

Die Erfindung betrifft einen Bipolartransistor, sowie ein Verfahren zur Herstellung eines solchen.

Halbleitervorrichtungen, wie z. B. der Bipolartransistor, gehören seit langem zum Stand der Technik und werden in vielfältiger Weise eingesetzt, z. B. in analogen und digitalen integrierten Schaltungen. Zu den Bestandteilen eines Bipolartransistors zählen ein Emitter als Ladungsträgerquelle, ein Kollektor als Ladungsträgersenke (Ladungsträgerabfluss) sowie eine Basis als Steuereinrichtung zum Steuern des Stromflusses zwischen dem Emitter und dem Kollektor.

Der Emitter und der Kollektor bestehen heutzutage häufig aus Silizium (chem. Zeichen: Si) eines bestimmten Leitfähigkeitstyps, wohingegen die Basis aus Silizium des entgegengesetzten Leitfähigkeitstyps besteht. Es existieren zwei verschiede Leitfähigkeitstypen in Halbleitermaterialien wie beispielsweise Silizium. Halbleitermaterialien mit Elektronen als Ladungsträgern nennt man n-leitend, solche mit Löchern als Ladungsträgern p-leitend. Im reinen Silizium liegen beide Sorten von Ladungsträgern in gleicher Konzentration vor, man spricht in diesem Fall von intrinsischem Silizium. Wird die Ladungsträgerkonzentration durch Einbringen von Fremdatomen, sog. Dotierstoffen, erhöht, spricht man von Dotierung. Eine n-Dotierung liegt vor, wenn der eingebrachte Dotierstoff ein n-Dotierstoff ist (Donator), also einer, der zu einer Zunahme der Konzentration an Elektronen als Ladungsträgern führt. Das Material wird dann n-leitend. Als n-Dotierstoff werden beispielsweise Phosphor (P), Arsen (As) und Antimon (Sb) verwendet. Andererseits liegt eine p-Dotierung vor, wenn der eingebrachte Dotierstoff ein p-Dotierstoff ist (Akzeptor), also einer, der zu einer Zunahme der Konzentration an Löchern als Ladungsträgern führt. Das Halbleitermaterial wird dann p-leitend. Als p-Dotierstoffe finden beispielsweise Bor (B), Indium (In) und Gallium (Ga) Verwendung. Ist die Zunahme der Konzentration an Elektronen/Löchern nach der Dotierung sehr groß oder sehr gering, liegt ein hoch dotiertes Halbleitermaterial (n⁺/p⁺-Dotierung) bzw. ein schwach dotiertes Halbleitermaterial (n⁻/p⁻-Dotierung) vor.

Für die Dotierung eines Halbleitermaterials stehen drei Verfahren zur Verfügung: die Ionen-Implantation und die Diffusion, jeweils nach der Erzeugung der zu dotierenden Schicht, sowie das Einbringen des Dotierstoffes in situ, also beim Abscheiden der zu dotierenden Schicht. Außerdem wird unterschieden, ob der Dotierstoff einen Zwischengitterplatz einnimmt, also interstitiell vorliegt, oder einen Gitterplatz in der Schicht einnimmt, also substitutionell eingebaut ist.

Beim oben beschriebenen Bipolartransistor kann es sich demnach beispielsweise um einen npn-Transistor handeln. Die Bezeichnung npn-Transistor bedeutet, dass Kollektor und Emitter n-dotiert sind, wohingegen die Basis p-dotiert ist. Statt einer Ausführung als npn-Transistor ist auch eine als pnp-Transistor möglich. In diesem Fall sind die Dotierungen im Vergleich zum npn-Transistor umgekehrt.

Man unterscheidet bei Bipolartransistoren horizontale Bipolartransistoren, nachfolgend auch laterale Bipolartransistoren genannt, in denen Kollektor, Basis und Emitter horizontal nebeneinander angeordnet sind, und vertikale Bipolartransistoren, in denen Kollektor, Basis und Emitter übereinander angeordnet sind. Häufig sind Bipolartransistoren in der Siliziumtechnik hergestellt (Si-Bipolartransistoren). Die Leistungsfähigkeit von vertikalen Si-Bipolartransistoren (engl.: Bipolar Junction Transistor BJT) im Hochgeschwindigkeitsbereich ist durch die Verwendung einer epitaxial hergestellten Basisschicht deutlich verbessert worden. Weitere Leistungsreserven wurden insbesondere mit der Integration einer epitaktisch erzeugten Schichtfolge umfassend Silizium (Si) / Silizium-Germanium-Legierung (SiGe) / Silizium (Si/SiGe/Si-Schichtfolge) in Bipolar- oder BiCMOS- Prozesse erreicht In die SiGe-Schicht wird die Dotierung für die Basis des Bipolartransistors eingebracht. Man spricht von einem SiGe-Heterobipolartransistor, kurz SiGe-HBT. Die gegenüber Si geringere Bandlücke in der SiGe-Schicht führt im Vergleich zu konventionellen Si-Bipolartransistoren zu einer erhöhten Injektion von Minoritätsladungsträgern in die Basis. Dieser physikalische Effekt, aber auch die schon im Industriemaßstab realisierbare präzise Abscheidung und Dotierung der Epitaxieschichten auf einer atomaren Längenskala wird ausgenutzt, um sowohl die Laufzeiten der Ladungsträger in der Basis als auch den Basiswiderstand zu verkleinern. Diese Eigenschaften ergeben höhere Transitfrequenzen f_{T} und maximale Schwingfrequenzen fₘₐₓ sowie geringeres Hochfrequenz (HF)-Rauschen. Eine zusätzliche Steigerung der Leistungsfähigkeit im Hochgeschwindigkeitsbereich erfordert die Reduktion der parasitären Komponenten, vor allem des externen Basis-Widerstandes, der Basis-Kollektor- sowie KollektorSubstrat-Kapazität, des Kollektor- Widerstandes als auch der LadungsträgerLaufzeit in der Basis-Kollektor-Raumladungszone.

Um die Anwendungsbreite von Bipolartransistoren in Schaltungen zu vergrößern, ist die Integration auf einem Chip von Transistoren mit unterschiedlichen Kollektor-Emitter-Durchbruchsspannungen (Abk. in der englischen Lit. BVCEO) vorteilhaft. Verschiedene BVCEO bewirken ein unterschiedliches Leistungsvermögen der Transistoren im Hochgeschwindigkeitsbereich. Die aus der Literatur bekannten Lösungen, vergl. z.B. A. Schüppen, M. Tortschanoff, J. Berntgen, P. Maier, D. Zerrweck, H. von der Ropp, J. Tolonics, and K. Burger: "The proleferation of Silicon Germanium", Cork Ireland, ESSDERC 2000, S. 88 ff, 11.-13. Sept. 2000, nutzen dafür selektiv implantierte Kollektor (SIC)- Gebiete, die den Anschluss zu einer vergrabenen, hochleitfähigen Schicht (engl. Buried Layer) herstellen. Über den Abstand der Buried Layer von der Basisschicht, der gleichzeitig die Ausdehnung einer niedrig dotierten Kollektorschicht (engl. Low doped Collector LDC) definiert, und die Dotierstoffkonzentration der SIC-Gebiete wird die Durchbruchsspannung eingestellt. Es ergeben sich unterschiedliche Forderungen an die LDC-Weite, wenn Transistoren mit unterschiedlicher SIC-Dotierung und folglich unterschiedlichem BVCEO hinsichtlich bestmöglicher Leistungsfähigkeit im Hochgeschwindigkeitsbereich hin optimiert werden sollen. Zwangsläufig ist bei dieser Lösung ein Kompromiss zu Lasten der Hochgeschwindigkeitseigenschaften der Transistoren mit kleinerer Durchbruchsspannung einzugehen. Grund dafür ist, dass für die Bereitstellung der größten angestrebten Durchbruchsspannung eine bestimmte Mindestweite des LDC nötig ist und dass für Transistoren mit kleinerer Durchbruchsspannung hieraus ein zusätzlicher, schädlicher Kollektorwiderstandsbeitrag resultiert, der zur Leistungsminderung im Höchstgeschwindigkeitsbereich führt. Dieser Nachteil lässt sich nur teilweise durch geeignete Gestaltung der SIC-Dotierung ausgleichen, weil hierbei Grenzen in der Profilsteilheit, Leitfähigkeit und Defektfreiheit gesetzt sind, die bei einer Buried Layer, insbesondere einer epitaktisch vergrabenen Buried Layer nicht bestehen.

Es existieren auch Lösungen, bei denen die Tiefe der Buried Layer nicht mit Hilfe einer Epitaxieschicht festgelegt wird, sondern bei denen die Tiefe des Dotierungsprofils durch die Energie der Ionen bei einer Implantation festgelegt wird (epitaxiefreie Buried Layer). Wegen der gegenläufigen Forderungen an die Implantationsparameter, die einerseits auf eine ausreichend große LDC-Weite abzielen und andererseits einen möglichst steilen Profilanstieg der Buried Layer anstreben, wurden mit den bekannten Konstruktionen auf Basis einer epitaxiefreien Buried Layer für größere BVCEO, d.h. etwa >6V, nicht die Leistungsparameter im Hochgeschwindigkeitsbereich erreicht, wie sie für eine epitaktisch vergrabene Buried Layer bekannt sind.

Neben der Forderung nach höherer Leistungsfähigkeit bewirkt insbesondere der Kostenfaktor Veränderungen der Transistorkonstruktion oder Prozesstechnologie, wie beispielsweise in WO 00/14806 vorgestellt. In dieser Veröffentlichung wird eine Transistorkonstruktion vorgeschlagen, die die ansonsten üblichen Merkmale Deep Trench und epitaktisch vergrabene, hoch dotierte Sub-Kollektorschicht vermeidet, ohne dabei nennenswerte Verschlechterungen in den Hochfrequenzeigenschaften durch erhöhte Kollektorwiderstände oder Kollektor-Substratkapazitäten in Kauf nehmen zu müssen. Mit dieser Anordnung sind z.B. jedoch keine Ergebnisse bekannt, die gleichzeitig BVCEO-Werte größer 6V und beste Hochfrequenzeigenschaften zeigen.

Aus US 6,171,894 ist ein Bipolartransistor gemäß dem Oberbegriff des Anspruchs 1 bekannte.

Gegenüber dem bekannten Stand der Technik stellt sich die Aufgabe, die benannten Nachteile zu verringern, insbesondere verbesserte Bipolartransistoren mit verschiedenen Durchbruchsspannungen auf kostengünstigere Weise herzustellen. Gegenüber dem in WO 00/14806 beschriebenen Stand der Technik stellt sich insbesondere die Aufgabe, die Transistoranordnung und die Verfahren zur Integration des Transistors z.B. in eine CMOS-Technologie weiter zu verbessern.

Diese Aufgaben werden durch einen Bipolartransistor nach Anspruch 1 sowie ein Verfahren nach Anspruch 3.

Bei der Halbleitervorrichtung nach Anspruch 1 kann es sich insbesondere um einen Bipolartransistor mit epitaxialer Basis handeln. In solch einem Bipolartransistor mit epitaxialer Basis liegen in einem Ausführungsbeispiel das innere Transistorgebiet, womit der aus Halbleitermaterial bestehende vertikale Streifen zwischen Emitter und Kollektor bezeichnet wird, der etwa die Breite des Emitterfensters besitzt, und der Kollektoranschluss und -kontaktbereich in ein und demselben aktiven Gebiet, kurz Transistorgebiet. Das heißt, das innere Transistorgebiet und der Kollektoranschluss- und Kontaktbereich sind nicht durch Isolationsgebiete, kurz Feldisolationsgebiete, die typischerweise einige 100nm in das Substrat hineinragen, getrennt. Weiterhin enthält der Bipolartransistor mit epitaxialer Basis an der Substratoberfläche des aktiven Transistorgebietes Isolationsgebiete 2. Art, die insbesondere zwischen innerem Basisgebiet und Kollektor-Kontaktgebiet liegen und die mit einer leitfähigen Schicht bedeckt sein können, die den Anschluss des Basiskontaktes an das innere Basisgebiet herstellt.

Außerdem kann der Bipolartransistor in der Ausführungsform mit epitaxialer Basis eine Pufferschicht enthalten, die den substratseitigen Teil des Epitaxie-Schichtstapels bildet, der auch die epitaxiale Basis enthält. Die Pufferschicht weist mindestens teilweise einkristallines Wachstum entlang der Seitenwand der Isolationsgebiete 2. Art auf.

Es kann eine Hoch-Dotierung vom Leitfähigkeitstyp der Basis in den polykristallinen Gebieten vorhanden sein, die den Anschluss zwischen Basis-Kontakt und innerem Basisgebiet herstellt, kurz polykristallines Basisanschlussgebiet. Sie ist in vertikaler Richtung mindestens um die Dicke des einkristallinen Teils der Pufferschicht von der Substratoberfläche entfernt. Eine solche Anordnung verbessert die Hochfrequenzeigenschaften durch Reduktion der Basis- und Kollektorwiderstände sowie durch verringerte Basis-Kollektor- und Kollektor-Substratkapazitäten.

In einer weiteren Ausgestaltung zeichnet sich der Bipolartransistor mit epitaxialer Basis durch eine Kollektor-Dotierung aus, die lateral durch die Seitenwand des Feldisolationsgebietes, welches das Transistorgebiet umschließt, begrenzt wird. In einer Ausgestaltung der Erfindung ist die Kollektor-Dotierung in der Weise ausgeführt, dass mindestens bis in eine Entfernung von 30nm von der Basisschicht die Konzentration Werte von 5x10¹⁷cm⁻³ nicht übersteigt.

Gemäß einer weiteren Ausgestaltung der Erfindung können die Feldisolationsgebiete aus flachen isolierenden Gräben, die in eine Tiefe von 300-600nm reichen, oder, gegebenenfalls zusätzlich, aus tiefen isolierenden Gräben mit einer Tiefenausdehnung von 1000-20000nm bestehen.

In einer weiteren Ausgestaltung der Erfindung, können die Isolationsgebiete 2. Art aus einer einzigen Art Isolationsmaterial oder aus einer Kombination von verschiedenen bestehen.

In einer weiteren Ausgestaltung der Erfindung, können die Seitenwände der Isolationsgebiete 2. Art durch Spacer, die die Bekeimung mit Halbleitermaterial während eines Epitaxieschrittes beeinflussen, teilweise oder vollständig abgedeckt sein.

In einer Ausgestaltung der Erfindung sind die Isolationsgebiete 2. Art mindestens teilweise, bevorzugt vollständig, mit einem Metall oder einer Silizidschicht bedeckt. Diese Metall- oder Silizid- Schicht kann vollständig oder teilweise mit einer Halbleiterschicht abgedeckt sein.

Die innere Öffnung der Isolationsgebiete 2. Art, die einen Teil des inneren Transistorgebiets umschließt, ist in einer Ausführungsform von den Feldisolationsgebieten vollständig umschlossen.

Bevorzugt ist der laterale Abstand der inneren Öffnung der Isolationsgebiete 2. Art von der inneren Begrenzung der Feldisolationsgebiete mindestens 25nm.

In einer Ausgestaltung der Erfindung enthält die epitaxiale Basisschicht eine Legierung aus dem Substratmaterial und einem weiteren Halbleitermaterial. Besteht das Substratmaterial aus Si, können Legierungen mit Ge oder C enthalten sein.

In einer Ausgestaltung der Erfindung können auch eine Si-Puffer- oder Si-Cap-Schicht -C in einer Konzentration von 5x10¹⁸cm⁻³ bis 2.5x10²⁰cm⁻³ enthalten, um die Diffusion bestimmter Dotierstoffe zu behindern oder zu beschleunigen, insbesondere um die Diffusion von Bor oder Phosphor zu behindern. Die Dotierung der Basis- oder Cap-Schicht mit C soll insbesondere die Diffusion einer Hochdotierung von Bor oder Phosphor aus den polykristallinen Basisanschlussgebieten in den einkristallinen Teil der Pufferschicht unterdrücken.

Weitere Ausführungsformen des erfindungsgemäßen Bipolartransistors sind in den abhängigen Ansprüchen angebeben.

Ein hier besonders bevorzugtes Verfahren zum Herstellen eines solchen Bipolartransistors umfasst die Schritte: Abscheiden einer Isolatorschicht auf einen Teil der Oberfläche eines aktiven Gebietes eines Halbleitersubstrats, welche das aktive Gebiet in einen Kollektor und mindestens ein Kollektorkontaktgebiet unterteilt, Abscheiden einer Basisschicht auf den Kollektor und Abscheiden einer polykristallinen Schicht auf die Isolatorschicht.

Das Verfahren ist insbesondere ein Verfahren zur Herstellung des Bipolartransistors mit epitaxialer Basis. Es beinhaltet in einer Ausgestaltung, dass die Kollektor-Dotierung so ausgeführt wird, dass kein weiterer Epitaxieschritt zwischen dem Einbringen der Kollektordotierung und dem Epitaxieschritt für die Basisherstellung, der auch die gemeinsame Erzeugung einer Puffer- und Cap-Schicht umfassen kann, angewendet wird.

In einem weiteren Verfahrensschritt kann die epitaxiale Basis oder der Schichtstapel Puffer-, Basis- und Cap-Schicht mit differentieller Epitaxie oder mit selektiver Epitaxie erzeugt oder durch Wechsel von einer zur anderen Epitaxieart hergestellt werden.

Gemäß der Erfindung umfasst der Bipolartransistor ein Substrat und einen Kollektor. Der Kollektor umfasst eine Kollektordotierung, deren Dotierungsprofil in vertikaler Richtung weitgehend homogen und zum Substrat hin kaum oder gar nicht ansteigend ausgebildet ist.

Insbesondere kann die beanspruchte Halbleitervorrichtung ein vertikaler oder lateraler Bipolartransistor sein, in dem im Kollektorgebiet eine im wesentlichen homogene, zum Substrat hin kaum oder gar nicht ansteigende Kollektordotierung (im Folgenden auch Kollektordotierung vierter Art genannt) angeordnet ist. Die Kollektordotierung vierter Art ist lateral wahlweise von einer Seite, zweiseitig, U- oder ringförmig von einer Hochdotierung umgeben.

Erfindungsgemäß reicht die Hochdotierung von der Substratoberfläche bis mindestens in eine Tiefe, die der substratseitigen Grenze der Basis-Kollektor-Raumladungszone bei Erreichen der Kollektor-Emitter-Durchbruchsspannung entspricht.

In einer weiteren Ausgestaltung der Erfindung ist eine Buried Layer, wie sie typischerweise als Sub-Kollektor für Bipolartransistoren verwendet wird oder eine Wanne, wie sie typischerweise für MOS-Transistoren benutzt wird, als Hochdotierung verwendet. Zusätzlich ist eine Source-Drain-Hochdotierung im oberflächennahen Bereich vorhanden.

In einer Ausgestaltung dieser Erfindung wird der laterale Abstand der Hochdotierung zum inneren Transistorgebiet geändert, wodurch ein zusätzlicher Freiheitsgrad zum Einstellen der Kollektor-Emitter-Durchbruchsspannung ausgenutzt wird.

In einer weiteren Ausgestaltung der Erfindung sind erfindungsgemäße Transistoren gemeinsam mit konventionellen Bipolartransistoren der Art, dass eine Buried Layer und/oder eine CMOS-Wanne durchgehend oder teilweise durchgehend unter dem inneren Transistorgebiet vorhanden ist, auf einem Chip hergestellt.

Diese Anordnung erlaubt es, Bipolartransistoren mit unterschiedlicher Kollektor-Emitter-Durchbruchsspannung mit geringerem Prozessaufwand als im Vergleich zu bekannten Lösungen und ohne Verschlechterung der Hochfrequenzeigenschaften der Transistorvarianten zu fertigen.

Gemäß einem weiteren Aspekt der Erfindung umfasst ein Verfahren zum Herstellen eines Bipolartransistors die in Anspruch 3 genannten Schritte

Das erfindungsgemäße Verfahren kann insbesondere zur Herstellung des oben beschriebenen Bipolartransistors verwendet werden. Es kann die Realisierung der Hochdotierung in einem einzelnen Dotierungsschritt oder in mehreren Dotierungsschritten beinhalten. Die Lage der Hochdotierung bezüglich der Substratoberfläche kann mittels Implantation eingestellt werden oder sie kann zusätzlich durch Aufbringen einer Epitaxieschicht variiert werden.

Nachfolgend wird die vorliegende Erfindung unter Bezugnahme auf die angefügten Abbildungen detailliert beschrieben.
- Fig. 1: zeigt den Querschnitt einer Halbleitervorrichtung in Form eines Bipolartransistors mit epitaxialer Basis.
- Fig. 2: zeigt Layout-Variante mit jeweils einseitigem Basis und Kollektorkontakt.
- Fig. 3: zeigt Layout-Variante mit jeweils zweiseitigem Basis und Kollektorkontakt.
- Fig. 4: zeigt den Querschnitt des einer erfindungsgemäßen Halbleitervorrichtung in Form eines Bipolartransistors.

### Beispiel 1:

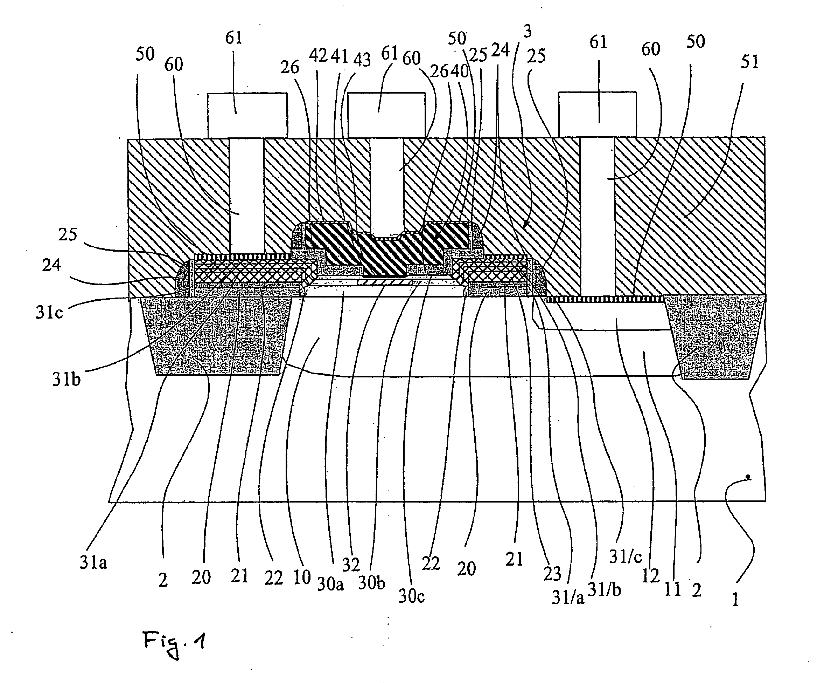

Ein Bipolartransistor mit epitaxialer Basis, für den hier kein Schutz beansprucht wird, wird nun in Bezug auf Fig. 1 erläutert. In diesem Beispiel ist ein npn-Bipolartransistor auf einem hochohmigen, einkristallinen p⁻- leitfähigen Si-Substrat 1 gefertigt. Die hier beschriebene Anordnung ist nicht auf p⁻-leitfähige Si- Substrate beschränkt. Die wesentlichen Merkmale können z.B. auch auf Verbindungshalbleiter oder Substrate vom entgegengesetzten Leitfähigkeitstyp übertragen werden. Der entgegengesetzte Leitfähigkeitstyp des Substrates ist ohne zusätzliche Maßnahmen im Falle eines pnp-Bipolartransistors einsetzbar. Die Beschreibung ist jedoch auch dann auf den pnp-Bipolartransistor anwendbar, wenn von einem p⁻-Substrat ausgegangen wird. In diesem Fall sind die Transistorgebiete zum Substrat hin durch eine kontaktierte n-Dotierung allseitig abzuschirmen. Diese Maßnahme lässt sich auch auf npn-Transistoren übertragen, wenn von n⁻-Substrat ausgegangen wird.

Der npn-Bipolartransistor mit epitaxialer Basis umfasst einen n-leitenden Kollektor 10, einen ebenfalls n-leitenden Emitter 40. Der Kollektor ist seitlich über das Kollektorkontaktgebiet 11 und eine Kollektoranschlussdotierung 12 zum Kontakt geführt. Zwischen Emitter 40 und Kollektor 10 befindet sich ein einkristalliner Schichtstapel 30, der sich seitlich als polykristalliner Schichtstapel 31 fortsetzt. Der Schichtstapel 30 enthält die p-leitende Basisschicht 30b. Die innere Basisschicht 32 wird in horizontaler Richtung etwa durch die Breite des Emitterfensters 41 definiert. Seitlich ist die innere Basisschicht 32 angeschlossen über einen einkristallinen Bereich der Basisschicht 30b und weiter außerhalb über die hoch leitfähige, übereinandergeschichtete Anordnung aus dem Schichtstapel 31 und der Schicht 23. Als Basisanschlussgebiet seien alle leitfähigen Teilbereiche bezeichnet, die den Anschluss zwischen innerer Basisschicht 32 und Basiskontakt herstellen.

Eine erste Art Isolationsgebiete 2, im weiteren als Feldisolationsgebiete bezeichnet, ragt von der Substratoberfläche aus ins Substratgebiet hinein. Als Feldisolationsgebiete können sogenannte "Shallow-Trench" Isolationen eingesetzt werden. Dabei handelt es sich um vorzugsweise 300 bis 600nm tiefe Gräben, die z.B. mit Siliziumdioxid (SiO₂), aber auch mit einer Kombination aus Isolatormaterial und Polysilizium verfüllt sein können. Aber auch mittels lokaler Oxidation (LOCOS) hergestellte Feldisolationsgebiete können eingesetzt werden. Außerdem sind auch zusätzlich zu den flachen Feldisolationsgebieten tiefe, z.B. mit SiO₂ verfüllte Gräben, sogenannte "Deep-Trenches", nutzbar, die jedoch in der Anordnung gemäß Fig. 1 nicht vorhanden sind. Zwischen den Feldisolationsgebieten 2 sind an der Substratoberfläche Inseln von einkristallinen Silizium-Gebieten, den sogenannten aktiven Gebieten vorhanden. In einem der aktiven Gebiete ist der Bipolartransistor mit epitaxialer Basis angeordnet. Er enthält den im Substrat liegenden Kollektor 10, der seitlich von den Seitenwänden der Feldisolationsgebiete 2 begrenzt wird. Auf der Substratoberfläche sind Isolationsgeblete 2. Art erzeugt. Im bevorzugten Fall bestehen diese aus vertikal übereinander geschichteten Isolatorschichten 20, 21. Es kann jedoch z.B. auch nur eine Isolatorschicht oder eine dritte verwendet werden. Anzahl, chemische Zusammensetzung und Dicke werden nach den Anforderungen der Prozessintegration und Bauelementeeigenschaften gewählt. Aus Sicht der Prozessintegration sind solche Eigenschaften wie die Selektivität beim nass- und trockenchemischen Ätzen oder die Eigenschaften als Schutzschicht für andere Prozessmodule, wie z.B. CMOS-Transistoren, ein Auswahlkriterium. In bezug auf die Bauelementeeigenschaften spielen die Kapazität der Schicht oder Schichten, aber auch das Anwachsverhalten von Epitaxieschichten in der Umgebung der Isolationsschichten eine wichtige Rolle.

Im beschriebenen Beispiel von Fig. 1 handelt es sich bei Schicht 20 um eine 1nm bis 100nm dicke, vorzugsweise 10 bis 50nm dicke SiO₂-Schicht. Darüber befindet sich eine 10nm bis 100nm, vorzugsweise 20nm bis 50nm dicke Siliziumnitrid-(Si₃N₄)Schicht 21. Im Beispiel von Fig. 1 liegen in der Ebene der Substratoberfläche zwei Teilbereiche des Isolationsgebietes 2. Art. Eines davon liegt sowohl auf Feldisolationsgebiet 2 als auch auf aktivem Gebiet, das zweite liegt vollständig auf aktivem Gebiet. Später wird gezeigt, dass die zwei Teilbereiche als Ring in der Ebene senkrecht zur Querschnittsebene in Fig.1 miteinander verbunden sind.

Bedeckt ist der Kollektor 10 mit dem einkristallinen Schichtstapel 30, der in einem Epitaxieschritt erzeugt wird. Substratseitig ist die einkristalline Pufferschicht 30a abgeschieden. Diese Schicht kann 5nm 150 nm, insbesondere 5 bis 80nm, vorzugsweise 20nm bis 130 nmm, insbesondere 20 bis 60nm dick sein. Oberhalb der Pufferschicht ist die p-dotierte Basisschicht 30b erzeugt. Die Dicke der Basisschicht kann 5nm bis 100nm, vorzugsweise 10nm bis 35nm betragen. Die Basisdotierung des beschriebenen npn-Si-Bipolartransistors kann in-situ, also während der Epitaxie oder nach dem Epitaxieschritt durch Implantation erzeugt werden. Vorzugsweise wird Bor in-situ als Basisdotierung eingebracht. Mit den bekannten Mitteln kann durch Einbau von Ge oder C ein Heterobipolartransistor auf Si-Basis hergestellt werden. In niedrigen Konzentrationen von kleiner 0.5% kann C vorteilhaft der Verminderung der Diffusion von Dotier-Stoffen dienen, deren Diffusion auf einem Wechselwirkungsmechanismus mit Zwischengitteratomen beruht. Dazu zählt neben Phosphor auch Bor, welches vorzugsweise als Dotierstoff für die Basis eines npn-Bipolartransistors verwendet wird. Über der Basisschicht folgt eine 10nm bis 100nm, vorzugsweise 20nm bis 50nm dicke Cap-Schicht 30c.

Arbeitet man mit selektiver Si-Epitaxie, wachsen nur auf Si-Gebieten während der Epitaxie Schichten. Bei differenzieller Si-Epitaxie werden auch auf Isolatorgebieten Si-Schichten abgeschieden. Die Anordnung mit epitaxialer Basis ist vorzugsweise durch differentielle Epitaxie entstanden.

Dabei ist es für die Funktion des Basisanschlusses unerheblich, ob auf den Isolationsgebieten 2. Art leitfähiges Material vorhanden ist oder nicht. Das Ausführungsbeispiel in Fig. 1 enthält auf den Isolationsgebieten 20, 21 eine leitfähige Schicht 23, die bereits vor der Epitaxie erzeugt wurde. Dabei kann es sich um Polysilizium, aber auch um eine Metall-Silizid-Schicht oder eine Kombination aus beidem handeln.

Wegen der Gefahr der Freisetzung von Metallatomen bei nachfolgenden Prozessschritten kann die Metall-Silizidschicht auch von anderen Materialien, z.B. Polysilizium umhüllt sein.

Bei Vorhandensein von Schicht 23 kann der Basisanschluss ohne zusätzliche Maßnahmen auch durch selektive Epitaxie verwirklicht werden. Bei differentieller Epitaxie wächst der polykristalline Schichtstapel 31 über dem Schichtstapel 20, 12, 23.

An den Seitenwänden der Isolatorschichten 20, 21 können, vorzugsweise aus SiO₂ bestehende Spacer 22 vorhanden sein. Diese Spacer sollen dafür ausgenutzt werden, die seitliche Bekeimung der Isolatorschichten 20, 21 während des Epitaxieschrittes zur Herstellung der epitaxialen Basis zu verzögern. Es ist an sich bekannt, dass zum Beispiel unter bestimmten Epitaxiebedingungen die Bekeimung auf SiO₂ später einsetzt als auf Si₃N₄. Dieser sogenannte Selektivitätsunterschied wird vorliegend ausgenutzt, um die Pufferschicht 30a am seitlichen Übergang zu den Isolationsgebieten 20, 21 wenigstens teilweise einkristallin wachsen zu lassen. Würde die Bekeimung an der Seitenwand nämlich vor oder gleichzeitig mit der Bekeimung der Siliziumoberfläche beginnen, würde die sogenannte Facette, d.h. die Grenzfläche zwischen dem einkristallinen Schichtstapel 30 und dem polykristallinen Schichtstapel 31, bis zur Oberfläche des Substratgebietes 1 reichen.

Ein mindestens teilweise einkristalliner Abschnitt der Pufferschicht, aber auch der Basis und Cap-Schicht, entlang der Seitenwand der Isolationsgebiete 2. Art 20, 21 kann auch durch Wechsel der Abscheideart von selektiv zu differentiell oder durch reine selektive Epitaxie erreicht werden. In diesem Fall können die Isolationsgebiete 2. Art auch vorzugsweise vollständig, oder wenigstens teilweise an der Oberfläche, aus SiO₂ bestehen, um eine polykristalline Bekeimung in der Umgebung des inneren Transistorgebietes während des epitaktischen Wachstums der Pufferschicht zu verhindern oder hinauszuzögern. Der Zweck dieses einkristallinen Abschnittes besteht darin, den Abstand von Hochdotierungen des Kollektors und des polykristallinen Basisanschlussgebietes in diesem Abschnitt kontrollieren zu können. So kann durch den Einbau von C in die Puffer- oder Basisschicht die Bor-Diffusion aus dem polykristallinen Basisanschlussgebiet effektiv unterdrückt werden. Eine polykristalline Brücke zwischen den Hochdotierungen bewirkt beschleunigte Diffusion und/oder erhöhte Leckströme.

Oberhalb des Schichtstapels 30 bzw. 31 befindet sich eine strukturierte Isolatorschicht 26. Diese kann vorzugsweise aus einer 10nm bis 150nm, insbesondere 10 bis 60nm , vorzugsweise aus 30 bis 50nm dicken SiO₂-Schicht bestehen. Sie kann aber auch aus einer Kombination verschiedener Isolatormaterialien zusammengesetzt sein.

Die Öffnung in der Isolatorschicht 26 über dem Schichtstapel 30 definiert das Emitterfenster 41. Zur Herstellung des Emitterfensters kann z.B. mit Hilfe einer Lackmaske eine Hilfsschicht, z.B. amorphes Si, strukturiert werden. Diese sogenannte Hartmaske, in Fig. 1 nicht dargestellt, wird eingesetzt, um in einem Nassätzschritt das Emitterfenster in die Isolatorschicht 26 zu übertragen. Eine hoch dotierte Siliziumschicht vom Leitungstyp des Kollektors, die Emitterschicht 42, bedeckt das Emitterfenster 41 sowie die Isolatorschicht 26.

Die Emitterschicht 42 kann als polykristallines, amorphes, partiell einkristallinespartiell polykristallines oder als einkristallines Material abgeschieden sein. Aus der hochdotierten Emitterschicht 42 kann während eines Hochtemperaturschrittes n-Dotierstoff in den Schichtstapel 30 durch das Emitterfenster 41 eindiffundiert sein. Der Emitter 40 umfasst in diesem Fall die Emitterschicht 42 sowie das eindiffundierte n-Gebiet 43. Die resultierende äußere Begrenzung der Emitterschicht 42 ist per Ätzung über eine Lackmaske vorzugsweise so gestaltet, dass die Seitenflächen der Emitterschicht 42 über die inneren Seitenflächen der Isolationsgebiete 2. Art 20, 21 seitlich hinausragen. Auf diese Weise kann nach der Ätzung der Emitterschicht 42 eine Dotierung des Schichtstapels 31 und der Schicht 23 vom Leitfähigkeitstyp der Basis per Implantation so erfolgen, dass die Ausläufer dieser Implantation vom Kollektor 10 ferngehalten werden.

Per Lackmaske wird die äußere Begrenzung der Schichten 30 und 23 strukturiert. Anschließend werden die Emitterschicht sowie die Isolatorschichten 2. Art 20, 21 und die Schichten 30 und 23 an den Seitenwänden mit einem Spacer versehen, bestehend aus einer Doppelschicht SiO₂/Si₃N₄ 24, 25.

Nach der Spacerbildung werden die mit einer vorzugsweise 1nm bis 20nm SiO₂ Restschicht bedeckten aktiven Gebiete nasschemisch freigeätzt. In einem folgenden Silizierungsschritt entstehen die im Vergleich zu hochdotiertem Si noch besser leitfähigen Silizidschichten 50.

Die Ausbildung dieser Spacer 24, 25 kann jedoch auch entfallen, da Emitter und Basis, bzw. Basis und Kollektor auch ohne diese Spacer durch die Isolatorschicht 26 bzw. durch die Isolationsgebiete 2. Art oder die Feldisolationsgebiete 2 nach einem Silizierungsschritt elektrisch voneinander isoliert sind. Diese hier nicht gegezeigte Variante kann den Vorteil bieten, dass auch die Seitenwände der Emitterschicht 42 und des polykristallinen Schichtstapels 31, 23 siliziert werden und Emitter- und Basiswiderstand reduziert werden können.

Die Oberfläche der Transistor- und Isolationsgebiete wird mit einer Isolatorschicht oder -schichtkombination 51 abgedeckt. Mit leitfähigem Material verfüllte Kontaktlöcher 60 und darüber liegende Metallstreifen 61 stellen den elektrischen Anschluss zu den Kontaktgebieten des Transistors her.

Das Kollektorgebiet 10 und das Kollektorkontaktgebiet 11 sind im betrachteten Beispiel eines npn-Bipolartransistors mit einer n- leitfähigen, ersten Kollektordotierung 13 versehen, die sich zwischen den Seitenwänden des angrenzenden Feldisolationsgebietes erstreckt. Die vertikale Ausdehnung erreicht vorzugsweise die Ausdehnung der Feldisolationsgebiete 2. Wenn die erste Kollektordotierung 13 vor dem Basis-Epitaxieschritt z.B. mit einer strukturierten Lackmaske eingebracht wird, kann durch Diffusion während einer Temperaturbehandlung Dotierstoff in die darüberliegende Pufferschicht 30a gelangen.

Die Dosis der Implantation wird bevorzugt so gewählt, dass ein geringer Kollektorwiderstand resultiert. Die Dosis kann im Bereich von 1x10¹³cm⁻² bis 5x10¹⁵cm⁻², vorzugsweise zwischen 2.5x10¹⁴cm⁻² bis 2x10¹⁵cm⁻², eingeschränkt zwischen 2.5x10¹⁴cm⁻² bis 1x10¹⁵cm⁻² und noch weiter eingeschränkt zwischen 2.5x10¹⁴cm⁻²bis 5x10¹⁴cm⁻² liegen. Ein zweiter bevorzugter Dosisbereich liegt zwischen 1x10¹⁵cm⁻² bis 5x10¹⁵cm⁻².

Als Ionen für die Implantation kommen Phosphor (P), Arsen (As) und Antimon (Sb) in Frage. Aus Gründen eines geringen Kollektorwiderstandes ist außerdem ein möglichst abrupter Anstieg der ersten Kollektordotierung 13 auf der emitterseitigen Flanke des Profils vorteilhaft. Dies lässt sich z.B. durch Implantation mit As oder Sb erreichen.

In der nachfolgenden Tabelle sind in der linken Spalte verschiedene Energiebereiche für die Implantation von As oder Sb aufgelistet. In der mittleren Spalte sind die entsprechenden Tiefen des Maximums das As-Profils angegeben, in der rechten Spalte die entsprechenden Tiefen des Maximums des Sb-Profils.

| Energiebereich [keV] | Tiefe des Profilmaximums bei As-Dotierung [nm] | Tiefe des Profilmaximums bei Sb-Dotierung [nm] |
|---|---|---|
| 50...1000 | 35...600 | 25...400 |
| 50...540 | 35...330 | 25...220 |
| 50...500 | 35...300 | 25...220 |
| 50...270 | 35...170 | 25...120 |
| 300...540 | 170...330 | 120...220 |
| 300...500 | 170...300 | 120...220 |
| 400...540 | 230...330 | 160...220 |
| 400...500 | 230...300 | 160...220 |

In der nachfolgenden Tabelle sind in der linken Spalte verschiedene Energiebereiche für die Implantation von P aufgelistet. In der rechten Spalte sind die entsprechenden Tiefen des Maximums das P-Profils angegeben.

| Energiebereich [keV] | Tiefe des Profilmaximums bei P-Dotierung [nm] |
|---|---|
| 100... 540 | 130...750 |
| 100...500 | 130...700 |
| 200...540 | 270...750 |
| 200...500 | 270...700 |
| 300...540 | 410...750 |
| 300...500 | 410...700 |
| 300...400 | 410...570 |

Es können auch mehrere Implante, die sich nach Ionensorte, Energie und Dosis unterscheiden können, eingebracht werden.

Ferner können sogenannte Pre-Amorphisierungsimplante, d.h. Implante die gezielt in einer bestimmten Region den Halbleiterkristall zerstören, eingesetzt werden. Dafür eignen sich insbesondere elektrisch neutrale Implantationsstoffe, wie Si oder Ge für die Implantation ins Si. Mit Hilfe dieser Implantationen kann auf die Perfektion der ausgeheilten (rekristallisierten) Gebiete Einfluss genommen werden.

Außerdem können Deckschichten, wie z.B. die Isolatorschichten zur Realisierung der Isolationsgebiete 2.Art, bei der Implantation gezielt genutzt werden, um die Eindringtiefe zu variieren.

Für hier nicht beanspruchte Ausführungsformen von Höchstgeschwindigkeitstransistoren wird das Profil der ersten Kollektordotierung so gestaltet, dass nach allen Diffusionsschritten an der basisseitigen Flanke die Konzentration innerhalb von weniger als 150nm mindestens um 2 Größenordnungen, vorzugsweise innerhalb von weniger als 80nm um mindestens 2 Größenordnungen, noch weiter eingeschränkt innerhalb von weniger als 40nm um mindestens 2 Größenordnungen, zunimmt. Die Kollektordotierung kann hierbei beispielsweise von einem Referenzniveau von mindestens 1x10¹⁷cm⁻³ ausgehend zunehmen. Jedoch sind auch andere Referenzniveaus größer 1x10¹⁷cm⁻³, vorzugsweise bis 3x10¹⁸cm⁻3 vorteilhaft. Die Zunahme der Dotierstoffkonzentration um mindestens 2 Größenordnungen über die angegebenen Tiefenbereiche erfolgt vorzugsweise in der Art, dass der hiermit ausgezeichnete Abschnitt des Kollektorprofils an der kollektorseitigen Basisgrenze beginnt.

Eine zweite Kollektordotierung 14 wird in solchen nicht beanspruchten Ausführungsformen in der lateralen Ausdehnung durch die Breite der Öffnung in den Isolationsgebieten 2. Art 20, 21 festgelegt. Sie kann gleichzeitig mit der Lackmaske zur Strukturierung der Isolationsgebiete 2. Art per Implantation eingebracht werden und ist in diesem Fall in allen Bipolartransistoren der in Beispiel 1 beschriebenen Art enthalten.

Für die 2. Kollektordotierung gelten in solchen nicht beanspruchten Ausführungsformen bei der Fabrikation von Höchstgeschwindigkeitstransistoren bevorzugt gleiche Profilvorgaben wie für die erste Kollektordotierung.

Die zweite Kollektordotierung kann zusätzlich zur ersten eingebracht werden oder sie kann entfallen.

Da an die Strukturierung der Lackmaske für die erste Kollektordotierung im Unterschied zur Strukturierung der zweiten keine weiteren Forderungen gestellt werden, kann die erste Kollektordotierung wahlweise in jeden Transistor eingebracht werden.

Die Verwendung der ersten und zweiten Kollektordotierung bietet den Vorteil, dass dadurch Transistoren mit unterschiedlichen Parametern entstehen und damit verschiedene Schaltungsanforderungen erfüllt werden können. Wird als zweite Kollektordotierung ein Profil mit geringerer maximaler Dotierstoffkonzentration, vorzugsweise kleiner als 3x10¹⁷cm⁻³, gewählt, kann durch Maskierung der ersten Kollektordotierung per Layout bei einer zweiten Art von Bipolartransistoren auf ein und demselben Substrat eine höhere Kollektor-Emitter-Durchbruchsspannung erreicht werden als bei den Transistoren erster Art, die die erste und zweite Kollektordotierung enthalten.

Eine dritte Kollektordotierung 15 kann gleichzeitig mit der Strukturierung des Emitterfensters 41 eingebracht werden. Die Kollektordotierung 15 ist dann selbstpositioniert zum Emitterfenster 41. In diesem Fall sind alle Bipolartransistoren von der Implantation betroffen. Es ist aber auch möglich, mit Hilfe einer extra Lackmaske die dritte Kollektordotierung lediglich in eine Teilmenge der Bipolartransistoren einzubringen. Die dritte Kollektordotierung ist dann jedoch nicht selbstpositioniert zum Emitterfenster angeordnet.

Der Anschluss des Kollektors erfolgt über die Kollektoranschlussdotierung 12. Die laterale Ausdehnung wird zum einen durch das Feldisolationsgebiet 2 begrenzt. Zum anderen kann die Kollektoranschlussdotierung bis an die Öffnung des Isolationsgebietes 2. Art 20, 21 heranreichen oder bereits an der äußeren Kante dieses Gebietes enden.

Die Kollektoranschlussdotierung kann aus mehreren Implanten zusammensetzt sein. So kann z.B. in einem BiCMOS-Prozess die Dotierung der n-Source/Drain-Gebiete der MOS-Transistoren oder zusätzlich die n-Wanne, die für die Herstellung der pMOS Transistoren benötigt wird, verwendet werden.

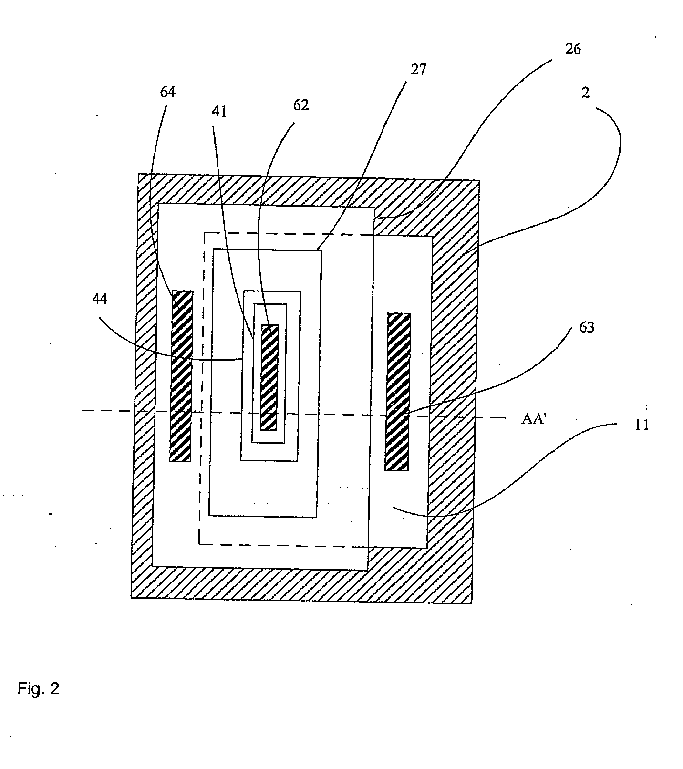

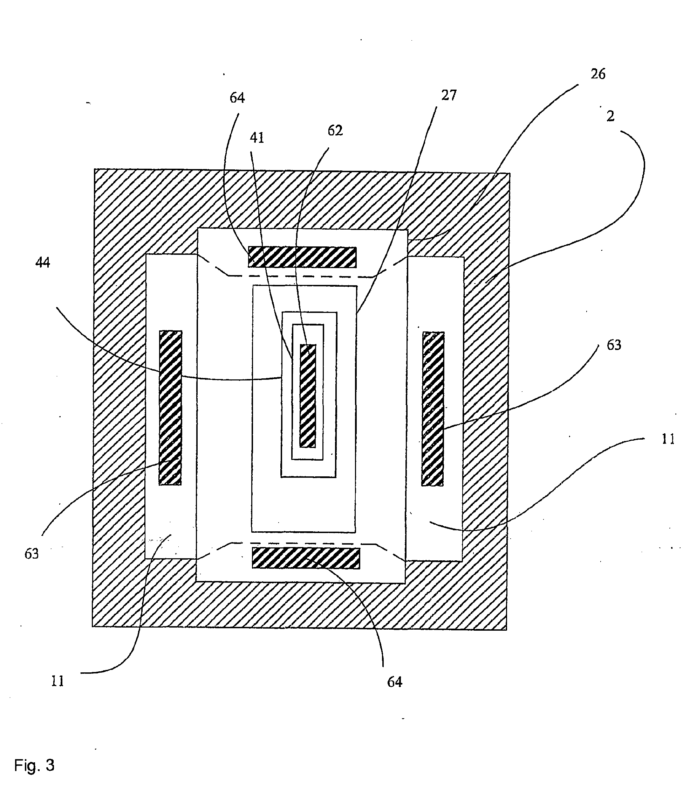

In den Figuren 2 und 3 sind Layout-Varianten, d.h. Draufsichten der wesentlichen Strukturierungsebenen der Anordnung mit epitaxialer Basis, dargestellt. Das Feldisolationsgebiet 2 umschließt das Kollektoranschlussgebiet 11, die innere Berandung der Isolationsgebiete 2. Art 27, die Emitterschicht 44, das Emitterfenster 41. Emitter, Basis und Kollektor sind über die Kontaktgebiete 62, 63 und 64 angeschlossen. In Fig. 2 ist ein Layout-Beispiel abgebildet, das entlang der Schnittlinie AA' zum Querschnitt der Anordnung von Fig. 1 korrespondiert. Dabei sind Basiskontakt 64 und Kollektorkontakt 63 jeweils auf einer Seite angeordnet. Fig. 3 zeigt eine Variante, bei der jeweils zwei sich gegenüberliegende Basis- 64 und Kollektorkontakte 63 vorhanden sind. Im Sinne dieser Varianten lassen sich durch den Fachmann leicht weitere Layout-Varianten angeben.

### Beispiel 2:

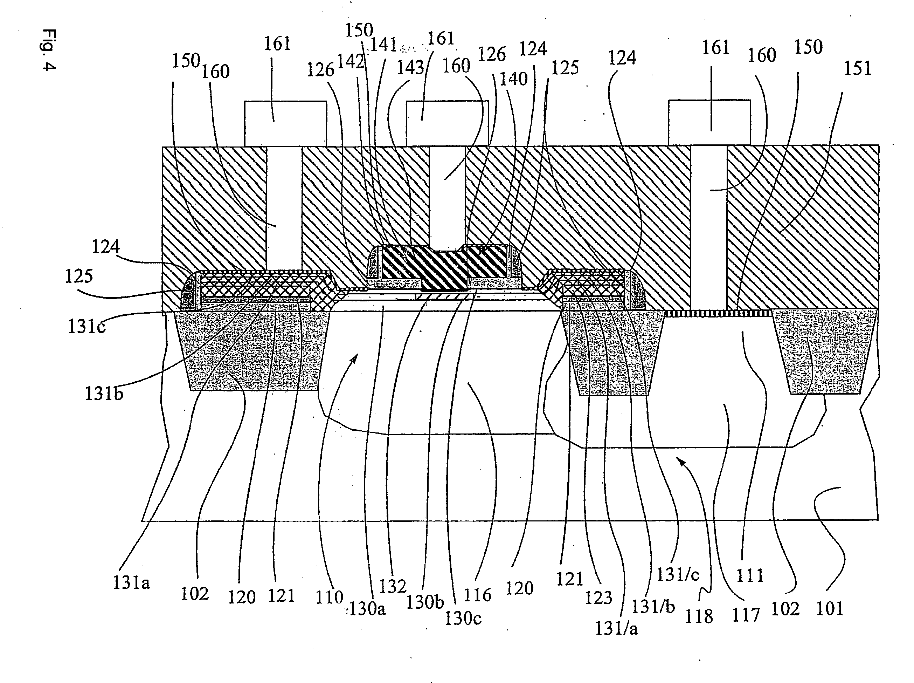

Der erfindungsgemäße Bipolartransistor wird nun anhand eines weiteren Ausführungsbeispiels unter Bezug auf Fig. 4 erläutert. Voneinander abweichende Merkmale im Vergleich zwischen Beispiel 1 und 2 sind: Der Kollektor 110 ist seitlich über das Kollektoranschlussgebiet 117 zum Kollektorkontakt 111 geführt. Als Kollektoranschlussgebiet 117 wird der gesamte, außerhalb des inneren Transistorgebietes liegende Bereich bezeichnet, der im Halbleitergebiet die elektrische Verbindung zum Kollektorkontakt herstellt. Das innere Transistorgebiet kann, muss aber nicht mit dem Kollektorkontaktgebiet 111 in ein und demselben aktiven Gebiet liegen. Damit sind auch alle ausgestaltenden Merkmale der Kollektordotierung hinfällig, die sich auf die Lage des Transistorgebietes in einem einzigen aktiven Gebiet beziehen.

Im Beispiel 2 sind das innere Transistorgebiet und das Kollektorkontaktgebiet 111 durch ein Feldisolationsgebiet 102 voneinander getrennt. Zwischen dem Emitter 140 und dem Kollektor 110 kann, muss aber kein einkristalliner Schichtstapel 130 vorhanden sein, wie in Beispiel 2 ausgeführt. Es ist auch möglich eine Basisschicht mit den üblichen Mitteln mittels Implantation oder Eindiffusion herzustellen. Ob die Basis dann, wie in Beispiel 2 gezeigt, auf Isolationsgebiet angeschlossen ist oder nicht, hängt von der Ausgestaltung der Technologie ab, ist jedoch für das Wesen der erfindungsgemäßen Anordnung von Beispiel 2 nicht von Bedeutung.

Die im Beispiel 2 vorhandenen Isolationsgebiete 2. Art 120, 121 liefern Möglichkeiten, die Integration des Bipolartransistors in einen CMOS-Prozess zu erleichtern und die in Beispiel 1 genannten Eigenschaften von Bipolartransistoren zu verbessern. Sie sind jedoch für die erfindungsgemäße Anordnung von Beispiel 2 nicht wesentlich. Aus diesen Gründen ist im Beispiel 2 auch auf die Ausbildung von Spacern an der Innenwand der Isolationsgebiete 2. Art verzichtet worden.

Aufbau und Herstellung des Emitters 140 und dafür erforderlicher Hilfsschichten können, aber müssen nicht identisch zum Beispiel 1 ausgeführt werden. Es sind auch übliche Methoden zur Herstellung eines implantierten Emitters anwendbar.

Von wesentlicher Bedeutung für die im Beispiel 2 beschriebene Anordnung ist das Vorhandensein einer vierten Kollektordotierung 116 die in horizontaler Richtung mindestens das innere Transistorgebiet umfasst. Der Profilverlauf in vertikaler Richtung ist im wesentlichen homogen, und es fehlt der im inneren Transistorgebiet für übliche Kollektorprofile, wie z.B. bei einer Buried Layer, charakteristische, möglichst steil ansteigende Teil, der für sogenannte retrograde Profile kennzeichnend ist. Die Konzentration der vierten Kollektordotierung ist so gestaltet, dass die angestrebte Kollektor-Emitter-Durchbruchsspannung erreicht werden kann.

Außerdem ist die Anordnung im Beispiel 2 gekennzeichnet durch die Hochdotierung 118, die seitlich an die vierte Kollektordotierung 116 heranreicht oder diese teilweise überdeckt. Diese Dotierung ist so ausgebildet, dass ein niederohmiger Anschluss zum Kollektorkontakt entsteht.

Die Hochdotierung 118 kann durch eine spezielle, sogenannte Kollektorschacht-Implantation oder, in Abhängigkeit vom Prozessablauf, aus mehreren Dotierungen vom Leitungstyp des Kollektors gebildet werden. Dafür steht im Bipolarprozess z.B. die Buried-Layer-Dotierung zur Verfügung. Im BiCMOS-Prozess können, je nach Bipolartransistortyp, n- oder p-Wanne sowie im oberflächennahen Bereich die Hochdotierungen für Source/Drain eingebracht werden.

Die Tiefe und der seitliche Abstand der Hochdotierung 118 zum inneren Transistorgebiet sind bevorzugter Weise so gestaltet, dass die seitliche Ausbreitung der Kollektor-Basis-Raumladungszone unter Betriebsbedingungen die angestrebte Kollektor-Emitter-Durchbruchsspannung ermöglicht. Außerdem kann der Kollektorwiderstand reduziert werden, wenn die Hochdotierung 118 an die vierte Kollektordotierung nicht nur einseitig heranreicht sondern diese auch zweiseitig, U-förmig oder ringförmig einschließt. Diese Anordnung kann per Layout hergestellt werden. Durch diesen Aufbau ist es offensichtlich möglich, größere Kollektor-Emitter-Durchbruchsspannungen zu erzielen, >6V, bei gleichzeitiger Einstellung üblicher Stromverstärkungswerte >70, ohne auf die Anwendung einer Hochenergie-Implantation oder eine epitaktisch vergrabene Buried Layer angewiesen zu sein und ohne dass Einbußen im Hochgeschwindigkeitsverhalten hingenommen werden müssen.

Ein zusätzlicher Freiheitsgrad für die Einstellung von BVCEO besteht bei der erfindungsgemäßen Anordnung, indem der seitliche Abstand der Hochdotierung 118 zum inneren Transistorgebiet per Layout verändert wird. Zur Verringerung des Kollektorwiderstandsbeitrages, der durch den Strompfad in der Hochdotierung 118 entsteht, kann eine gezielte Einstellung der seitlichen Randkontur der Hochdotierung unter Berücksichtigung der Ausbreitung der Ladungsträger in der Kollektor-Basis-Raumladungszone genutzt werden. Diese Gestaltungsvariante geht von der Tatsache aus, dass moderne Hochgeschwindigkeitstransistoren Emitterbreiten (kürzeste laterale Ausdehnung des Emitterfensters) besitzen, die etwa der Länge der Basis-Kollektor-Raumladungszone entsprechen, die Transistoren mit BVCEO> 4 bis 5V mindestens benötigen. Bei diesen Transistoren kann der Kollektorwiderstand gesenkt werden, wenn die Flugzeit der Ladungsträger und die Ladungsträgermultiplikation in der Basis-Kollektor-Raumladungszone gleichzeitig minimiert wird. Vorteilhaft kann dafür eine seitliche Auswölbung des Gebietes der Hochdotierung, die sich an die radial- oder zylindersymmetrische Gestalt der kollektorseitigen Basis-Kollektor-Raumladungszonengrenze anpasst, eingesetzt werden. Insbesondere kann auf Kosten einer höheren Kapazität zwischen Basisanschlussgebiet und Kollektor, die mit geringerem Gewicht die Hochgeschwindigkeitseigenschaften beeinflusst als die Kapazität zwischen innerer Basis und Kollektor, der Kollektorwiderstand durch seitliche Ausläufer der Hochdotierung 118, die der Dotierung des Basisanschlusses gegenüberstehen, gesenkt werden, ohne dass die Kollektor-Emitter-Durchbruchsspannung leidet. Radialsymmetrisch bzw. zylindersymmetrisch sind hierbei nicht im strengen mathematischen Sinne zu verstehen sondern als Annäherung an die tatsächliche Form, die beispielsweise auch birnenförmig sein kann.

## Patentansprüche

1. Bipolartransistor, umfassend
- ein Substrat (101),
- eine Basis (130b),
- ein inneres Transistorgebiet, das einen aus Halbleitermaterial bestehenden vertikalen Streifen bildet, der sich in vertikaler Richtung zwischen einem Emitter (140) und einem Kollektor (110) erstreckt und der in lateraler Richtung eine Breite aufweist, die einem durch eine Öffnung einer Isolatorschicht (126) gebildeten Emitterfenster (141) entspricht,
- wobei der Kollektor (110) eine Kollektordotierung (116) umfasst, deren Dotierungsprofil in vertikaler Richtung weitgehend homogen und zum Substrat (101) hin kaum oder gar nicht ansteigend ausgebildet ist,
- ein Kollektorkontaktgebiet (111)
- eine Hochdotierung (118), welche als niederohmiger Anschluss zum Kollektorkontaktgebiet (111) ausgestaltet ist, und,
- dass die Hochdotierung (118) lateral an die Kollektordotierung (116) heranreicht oder diese teilweise überdeckt und vom inneren Transistorgebiet lateral beabstandet angeordnet ist,
**dadurch gekennzeichnet,**
- **dass** die Kollektordotierung (116) lateral zweiseitig oder U-förmig oder ringförmig, jedoch nicht unterhalb der Kollektordotierung von der Hochdotierung umgeben ist, und
- **dass** die Hochdotierung (118) von einer Oberfläche des Substrates (101) bis mindestens in eine Tiefe reicht, die einer substratseitigen Grenze einer Raumladungszone zwischen der Basis (130b) und dem Kollektor (110) entspricht, die vorliegt, wenn zwischen dem Kollektor (110) und dem Emitter (140) eine Spannung anliegt, die zu einem Kollektor-Emitter-Durchbruch führt.

2. Bipolartransistor nach Anspruch 1, bei dem das Kollektorkontaktgebiet (111) vom Kollektor (110) lateral durch ein Feldisolationsgebiet (102) getrennt ist.

3. Verfahren zum Herstellen eines Bipolartransistors umfassend die Schritte:
Einbringen einer Kollektordotierung (116) in ein Substrat (101) derart, dass das Dotierungsprofil in vertikaler Richtung weitgehend homogen und zum Substrat hin kaum oder gar nicht ansteigend ausgebildet wird,
Herstellen einer Basis (130b),
Einbringen einer Hochdotierung (118), welche als niederohmiger Anschluss zum Kollektorkontaktgebiet (111) ausgestaltet ist, derart, dass die Hochdotierung lateral an die Kollektordotierung (116) heranreicht oder diese teilweise überdeckt und die Kollektordotierung lateral zweiseitig oder U-förmig oder ringförmig umgibt, wobei die Hochdotierung von einem inneren Transistorgebiet lateral beabstandet angeordnet wird, das von einem aus Halbleitermaterial bestehenden vertikalen Streifen gebildet ist, der sich in vertikaler Richtung zwischen einem Emitter (140) und einem Kollektor (110) erstreckt und in lateraler Richtung eine Breite aufweist, die einem durch eine Öffnung einer Isolatorschicht (126) gebildeten Emitterfenster (141) entspricht, und wobei die Hochdotierung nicht in vertikaler Richtung unterhalb der Kollektordotierung angeordnet wird,
und bei dem die Hochdotierung (118) von einer Oberfläche des Substrates (101) bis mindestens in eine Tiefe reichend hergestellt wird, die einer substratseitigen Grenze einer Raumladungszone zwischen der Basis (130b) und dem Kollektor (110) entspricht, die vorliegt, wenn zwischen dem Kollektor (110) und dem Emitter (140) eine Spannung anliegt, die zu einem Kollektor-Emitter-Durchbruch führt.

4. Verfahren nach Anspruch 3, **dadurch gekennzeichnet, dass** der Grad des Überdeckens so gewählt ist, dass die Kollektor-Emitter-Durchbruchsspannung auf einen vorbestimmten Wert eingestellt wird.

5. Verfahren nach Anspruch 3 oder 4, **dadurch gekennzeichnet, dass** die Hochdotierung (118) in mehreren Schritten eingebracht wird.

6. Verfahren nach einem der Ansprüche 3 bis 5, **dadurch gekennzeichnet, dass** mindestens ein Teil der Hochdotierung (118) zusammen mit einer Wanne, die für einen MOS-Transistor Verwendung findet, eingebracht wird.

## Claims

1. Bipolar transistor, comprising
- a substrate (101),
- a base (130b),
- an inner transistor region which forms a vertical strip consisting of semiconductor material which extends vertically between an emitter (140) and a collector (110) and which has, in the lateral direction, a width that corresponds to an emitter window (141) formed by an opening in an insulation layer (126), the collector (110) comprising a collector doping (116) the doping profile of which in the vertical direction is of substantially homogeneous configuration, rising scarcely or not at all towards the substrate (101),
- a collector contact region (111)
- a high doping (118) which is embodied as a low-ohmic connection to the collector contact region (111), and
- the high doping (118) extends laterally to or partially overlaps the collector doping (116) and is arranged at a lateral spacing from the inner transistor region,
**characterised in that**
- the collector doping (116) is surrounded by the high doping laterally on both sides or in a U shape or ring shape, but not underneath the collector doping, and
- the high doping (118) extends from a surface of the substrate (101) down to at least a depth which corresponds to a substrate-side limit of a spatial charging zone between the base (130b) and the collector (110), which is present when there is a voltage between the collector (110) and the emitter (14) which leads to a collector-emitter breakdown.

2. Bipolar transistor according to claim 1, wherein the collector contact region (111) is separated from the collector (110) laterally by a field insulation region (102).

3. Method for producing a bipolar transistor, comprising the steps of:
introducing a collector doping (116) into a substrate (101) such that the doping profile in the vertical direction is of substantially homogeneous configuration, rising scarcely or not at all towards the substrate (101),
producing a base (130b),
introducing a high doping (118) which is embodied as a low-ohmic connection to the collector contact region (111), such that the high doping extends laterally to or partially overlaps the collector doping (116) and surrounds the collector doping laterally on both sides or in a U shape or ring shape, the high doping being arranged at a lateral spacing from an inner transistor region which is formed from a vertical strip consisting of semiconductor material, said strip extending vertically between an emitter (140) and a collector (110) and which has, in the lateral direction, a width that corresponds to an emitter window (141) formed by an opening in an insulation layer (126), and wherein the high doping is not arranged vertically below the collector doping,
and wherein the high doping (118) is produced from a surface of the substrate (101) down to at least a depth which corresponds to a substrate-side limit of a spatial charging zone between the base (130b) and the collector (110) which is present when there is a voltage between the collector (110) and the emitter (140) which leads to a collector-emitter breakdown.

4. Method according to claim 3, **characterised in that** the degree of overlap is selected such that the collector-emitter breakdown voltage is adjusted to a predetermined value.

5. Method according to claim 3 or 4, **characterised in that** the high doping (118) is introduced in several steps.

6. Method according to one of claims 3 to 5, **characterised in that** at least some of the high doping (118) is introduced together with a well which is used for an MOS transistor.

## Revendications

1. Transistor bipolaire comprenant :
- un substrat (101),
- une base (130b),
- une région de transistor interne, qui forme une bande verticale constituée de matériau semi-conducteur, qui s'étend verticalement entre un émetteur (140) et un collecteur (110) et qui comprend, dans la direction latérale, une largeur qui correspond à une fenêtre d'émetteur (141) constituée d'une ouverture dans une couche isolante (126), le collecteur (110) comprenant un dopage de collecteur (116) dont le profil de dopage est largement homogène dans le sens vertical et augmente faiblement ou pas du tout en direction du substrat (101),
- une région de contact du collecteur (111),
- un dopage élevé (118) conçu comme un branchement à faible résistance avec la région de contact du collecteur (111), et
- le dopage élevé (118) atteint latéralement le dopage du collecteur (116) ou le recouvre partiellement et est disposé latéralement à une certaine distance de la région de transistor interne,
**caractérisé en ce que**
- le dopage du collecteur (116) est entouré par le dopage élevé, des deux côtés ou sous la forme d'un U ou sous une forme annulaire, cependant pas en dessous du dopage du collecteur, et
- **en ce que** le dopage élevé (118) va d'une surface du substrat (101) jusqu'à au moins une profondeur qui correspond à une limite du côté du substrat d'une zone de charge d'espace entre la base (130b) et le collecteur (110), qui apparaît lorsque, entre le collecteur (110) et l'émetteur (140), une tension est appliquée, qui provoque un claquage collecteur-émetteur.

2. Transistor bipolaire selon la revendication 1, dans lequel la région de contact du collecteur (111) est séparée latéralement du collecteur (110) par une région d'isolation de champ (102).

3. Procédé de fabrication d'un transistor bipolaire comprenant les étapes suivantes :
introduction d'un dopage de collecteur (116) dans un substrat (101), de façon à ce que le profil de dopage soit largement homogène dans le sens vertical et augmente faiblement ou pas du tout en direction du substrat,
réalisation d'une base (130b),
introduction d'un dopage élevé (118) conçu comme un branchement à faible résistance avec la région de contact du collecteur (111), de façon à ce que le dopage élevé atteigne latéralement le dopage du collecteur (116) ou le recouvre partiellement et le dopage du collecteur est entouré par le dopage élevé, des deux côtés ou sous la forme d'un U ou sous une forme annulaire, le dopage élevé étant disposé latéralement à une certaine distance d'une région de transistor interne, formée d'une bande verticale constituée d'un matériau semi-conducteur, qui s'étend dans le sens vertical entre un émetteur (140) et un collecteur (110) et présente, dans le sens latérale, une largeur qui correspond à une fenêtre d'émetteur (141) constituée d'une ouverture dans une couche isolante (126) et le dopage élevé n'étant pas disposé dans le sens vertical en dessous du dopage du collecteur,
et dans lequel le dopage élevé (118) est réalisé de façon à atteindre, à partir d'une surface du substrat (101), au moins une profondeur qui correspond à une limite du côté du substrat d'une zone de charge d'espace entre la base (130b) et le collecteur (110), qui apparaît lorsque, entre le collecteur (110) et l'émetteur (140), une tension est appliquée, qui provoque un claquage collecteur-émetteur.

4. Procédé selon la revendication 3, **caractérisé en ce que** le degré de recouvrement est choisi de façon à ce que la tension de claquage collecteur-émetteur soit réglée à une valeur prédéterminée.

5. Procédé selon la revendication 3 ou 4, **caractérisé en ce que** le dopage élevé (118) est introduit en plusieurs étapes.

6. Procédé selon l'une des revendications 3 à 5, **caractérisé en ce qu'**au moins une partie du dopage élevé (118) est introduite en même temps qu'un puits utilisé dans un transistor MOS.
